(19) Europäisches Patentamt / European Patent Office / Office européen des brevets

(11) **EP 2 281 206 B1**

## (12) EUROPÄISCHE PATENTSCHRIFT

(45) Veröffentlichungstag und Bekanntmachung des Hinweises auf die Patenterteilung:
**02.11.2011 Patentblatt 2011/44**

(21) Anmeldenummer: **09753307.9**

(22) Anmeldetag: **20.05.2009**

(51) Int Cl.:
**G01R 31/14** *(2006.01)*    **G01R 31/12** *(2006.01)*

(86) Internationale Anmeldenummer:
**PCT/AT2009/000211**

(87) Internationale Veröffentlichungsnummer:
**WO 2009/143543 (03.12.2009 Gazette 2009/49)**

(54) **VLF-PRÜFGENERATOR**

VLF TEST GENERATOR

GÉNÉRATEUR DE TRÈS BASSE FRÉQUENCE POUR ESSAIS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **28.05.2008 AT 8562008**

(43) Veröffentlichungstag der Anmeldung:
**09.02.2011 Patentblatt 2011/06**

(73) Patentinhaber: **Mohaupt High Voltage GmbH 6142 Mieders (AT)**

(72) Erfinder: **Mohaupt, Peter 6020 Innsbruck (AT)**

(74) Vertreter: **Weiser, Andreas Patentanwalt Kopfgasse 7 1130 Wien (AT)**

(56) Entgegenhaltungen:
**DE-B3- 10 333 241    GB-A- 1 008 461**

**Beschreibung**

Die vorliegende Erfindung betrifft einen VLF-Prüfgenerator zur Erzeugung einer Hochspannung mit Tieffrequenz für die Isolationsprüfung von kapazitiven Lasten, insbesondere Energiekabeln, mit einem Oszillatorteil, der auf einem Ausgang eine Hochspannung hoher Frequenz erzeugt, die mit der Tieffrequenz moduliert ist, und einem daran angeschlossenen Demodulator zum Demodulieren der Hochspannung und Wiedergewinnen der Tieffrequenz daraus.

Für die energietechnische Isolationsprüfung von stark kapazitiven Lasten wie erdverlegten Kabelsystemen hat sich die Prüfung mit Hochspannungen sehr tiefer Frequenz ("very low frequency", VLF) im Bereich von Zehntel Hertz etabliert. Im Gegensatz zu netzfrequenten oder höherfrequenten Prüfspannungen rufen VLF-Prüfspannungen nur geringe Blindleistung in der kapazitiven Last hervor, so daß der Prüfgenerator entsprechend kleiner ausgelegt werden kann; und im Vergleich zu früher verwendeten Gleichspannungsprüfungen verhindern VLF-Prüfspannungen den Aufbau schädlicher Raum- und Restladungen im Kabelsystem, die später im Betrieb zu Durchschlägen führen können.

Die Erzeugung geeigneter VLF-Prüfspannungen im Hochspannungsbereich, d.h. mit bis zu einigen hundert Kilovolt, ist jedoch keineswegs einfach, da Hochspannungstransformatoren für derart tiefe Frequenzen nicht praktikabel sind. Es wurden daher bereits verschiedenste Schaltungen für VLF-Prüfgeneratoren vorgeschlagen, die jedoch alle entweder hohen Schaltungsaufwand oder kostspielige bzw. störungsanfällige Bauteile haben.

So ist beispielsweise aus der DE 103 33 241 B ein VLF-Prüfgenerator der eingangs genannten Art bekannt, welcher einen Stelltransformator mit motorgetriebener Verstellung verwendet, um eine netzfrequente Hochspannung durch periodische Verstellung des Transformators in der Amplitude zu modulieren. Die amplitudenmodulierte Hochspannung wird aufwärts transformiert, und anschließend wird mit Hilfe eines Demodulators die Modulationsfrequenz als VLF-Hochspannung wiedergewonnen. Der Demodulator ist durch einen in seiner Durchlaßrichtung umschaltbaren Diodengleichrichter gebildet und schaltet bei jeder Halbwelle der Tieffrequenz um, um die kapazitive Last mit jeder Halbwelle umzuladen. Der kapazitiven Last ist ein schaltbarer Entladewiderstand parallel geschaltet, um den Umladevorgang zu unterstützen. Ein derartiger lastparalleler Entladewiderstand hat jedoch hohe Verlustleistung zur Folge und/oder erfordert zusätzliche Schaltelektronik mit entsprechend erhöhten Kosten, Gewicht und Kühlbedarf.

Die Erfindung setzt sich zum Ziel, die Nachteile des bekannten Standes der Technik zu überwinden und einen VLF-Prüfgenerator für die Erzeugung tieffrequenter Hochspannungen zu schaffen, welcher einfach und kostengünstig realisiert werden kann, geringes Gewicht für einen transportablen Einsatz vor Ort hat, geringe Verlustleistung hat und dementsprechend geringe Kühlleistung erfordert.

Dieses Ziel wird mit einem VLF-Prüfgenerator der einleitend genannten Art erreicht, der sich gemäß der Erfindung dadurch auszeichnet, daß dem Demodulator ein zum genannten Ausgang zurückführender Entladewiderstand für die kapazitive Last parallelgeschaltet ist.

Gegenüber herkömmlichen Schaltungen mit einem permanenten lastparallelen Entladewiderstand hat die erfindungsgemäße Schaltung wesentlich geringere Verlustleistung; und im Vergleich zu Lösungen mit einem schaltbaren lastparallelen Entladewiderstand erübrigt die erfindungsgemäße Lösung einen gesonderten Schalter: Denn der auf das Ausgangspotential des Resonanzkreises bezogene Entladewiderstand kommt immer dann besonders stark zur Wirkung, wenn das Inferenzprodukt im Resonanzkreis seinen Schwebungsknoten hat und damit dem Nullpotential nahekommt. Dadurch kann eine signifikante Einsparung an Kosten, Gewicht, Verlustleistung und Kühlbedarf erreicht werden.

Die Demodulation der Tieffrequenz kann mit Hilfe jeder in der Technik bekannten Demodulatorschaltung bewerkstelligt werden. Eine schaltungstechnisch besonders einfache Lösung ergibt sich, wenn der Demodulator - wie an sich aus der genannten Schrift DE 103 33 241 B bekannt - die kapazitive Last mitverwendet und diese mittels eines Gleichrichters im Takt der Tieffrequenz umlädt. In diesem Fall besteht eine besonders vorteilhafte Ausführungsform der Erfindung darin, den Entladewiderstand einfach dem Gleichrichter parallelzuschalten.

Auch für den Gleichrichter kann jede in der Technik bekannte Gleichrichterschaltung verwendet werden. Besonders vorteilhaft ist es, wenn - wie an sich aus der DE 103 33 241 B bekannt - der Gleichrichter zwei antiparallele, mit Schaltern versehene Diodenzweige aufweist, wobei die Schalter zwischen den Diodenzweigen abwechselnd umschalten. In diesem Fall kann der Entladewiderstand den beiden Diodenzweigen einfach parallelgeschaltet werden, welche Lösung minimalen Bauteilebedarf hat.

In einer weiteren bevorzugten Ausführungsform der Erfindung wird jeder der genannten Diodenzweige durch eine Kette von Dioden und zwischenliegenden Halbleiterschaltern gebildet, wobei jeder Diode und jedem Halbleiterschalter ein einzelner Widerstand parallelgeschaltet ist, welche alle gemeinsam den genannten Entladewiderstand bilden. Dadurch kann die Anzahl an erforderlichen Bauteilen noch weiter reduziert und eine hohe Spannungsfestigkeit erreicht werden.

Gemäß noch einem weiteren bevorzugten Merkmal der Erfindung wird vorgesehen, daß die Schalter beim Umschalten kurzfristig überlappend gleichzeitig geschlossen sind. Dadurch kann der Einschwingvorgang der Generatorausgangsspannung beim Umschalten des Gleichrichters minimiert werden.

Besonders vorteilhaft ist es ferner, wenn gemäß einem weiteren Merkmal der Erfindung zusätzlich eine Steuereinrichtung für den Oszillatorteil vorgesehen ist, welche die Amplitude der Hochspannung am Ende jedes zweiten Viertels der Periode der Tieffrequenz reduziert, um die Entladung der kapazitiven Last über den Entladewiderstand zu unterstützen.

Auch für den Oszillatorteil kann jede in der Technik bekannten Oszillatorschaltung verwendet werden, welche eine tieffrequent modulierte Hochspannung erzeugen kann, beispielsweise elektromotorisch betätigte Stelltransformatoren, wie sie aus der DE 103 33 241 B an sich bekannt sind. Besonders günstig ist es jedoch, wenn der Oszillatorteil zwei Oszillatoren, deren Oszillatorfrequenzen sich um das Doppelte der genannten Tieffrequenz voneinander unterscheiden, und einen von den Oszillatoren interferierend gespeisten, auf die Oszillatorfrequenzen abgestimmten Resonanzkreis zur Spannungsüberhöhung der interferierenden Oszillatorfrequenzen aufweist, wobei der Demodulator die durch die Interferenz erzeugte Tieffrequenz aus dem Resonanzkreis auskoppelt und an die Last anlegt. In Abkehr von allen bekannten Lösungen beruht diese Ausführungsform auf dem neuen Ansatz, die Interferenz bzw. Schwebung zwischen zwei geringfügig differierenden Oszillatoren zur Erzeugung einer tieffrequenten Modulation in einem Resonanzkreis heranzuziehen, welcher gleichzeitig eine Spannungsüberhöhung des Interferenzproduktes bewirkt. Auf diese Weise kann mit überraschend wenigen Bauteilen eine Ausgangsspannung sehr hoher Amplitude und sehr tiefer Frequenz erzeugt werden. Störungsanfällige mechanische Elemente oder aufwendige Leistungselektroniken mit hohem Kühlbedarf entfallen zur Gänze. Aufgrund seines geringen Gewichts, Platzbedarfs und seiner Robustheit eignet sich der erfindungsgemäße VLF-Prüfgenerator besonders für den transportablen Einsatz bei Isolationsprüfungen vor Ort, z.B. von erdverlegten Energiekabeln.

Besonders günstig ist es, wenn gemäß einem weiteren Merkmal der Erfindung die Oszillatoren den Resonanzkreis über zumindest einen Transformator speisen, wodurch eine galvanische Trennung der Oszillatoren vom Resonanz- und damit Hochspannungskreis erreicht und negative Rückwirkungen transienter Vorgänge der Hochspannungsseite auf die Oszillatoren verhindert werden können; darüber hinaus kann auf diese Weise eine induktive Last für die Oszillatorausgänge bereitgestellt werden, wie sie beispielsweise von den genannten Power Modulen gefordert wird.

Eine besonders vorteilhafte Ausführungsform der Erfindung zeichnet sich dadurch aus, daß die Transformatoren gleichzeitig dazu verwendet werden, die Oszillatorausgangsspannungen für die Einspeisung in den Resonanzkreis hochzutransformieren. Dadurch kann eine nochmalige Erhöhung der Ausgangsspannung des VLF-Prüfgenerators erreicht werden.

Die Spannungsüberhöhung im Resonanzkreis eröffnet insbesondere auch die Möglichkeit, für die Oszillatoren herkömmliche steuerbare Halbleiter-Wechselrichter einzusetzen, wie sie in Form sog. "Power-Module" bekannt sind und z.B. aus einer netzfrequenten Versorgungsspannung von 400 V beliebige Ausgangsspannungsverläufe von bis zu 400 V erzeugen können; alleine durch die Spannungsüberhöhung im Resonanzkreis können daraus Ausgangsspannungen im Bereich von einigen zehn kV gewonnen werden.

Die Erfindung wird nachstehend anhand eines in den beigeschlossenen Zeichnungen dargestellten Ausführungsbeispieles näher erläutert. In den Zeichnungen zeigt:

Fig. 1 ein Schalbild einer ersten Ausführungsform eines VLF-Prüfgenerators;
Fig. 2 das im Resonanzkreis auftretende Interferenzprodukt, die Resonanzspannung $U_R$;
Fig. 3 die tieffrequente Modulation der Resonanzspannung $U_R$ nicht-maßstäblich vergrößert;
Fig. 4 ein Schaltbild einer zweiten Ausführungsform eines VLF-Prüfgenerators mit der erfindunsgemäßen Entladeschaltung;
Fig. 5 die Herabregelung der Oszillatorausgangsspannungen in jeder zweiten Viertelperiode der Tieffrequenz und die Schaltverläufe des Gleichrichters von Fig. 4 zur Unterstützung der Lastentladung;
die Fig. 6 und 7 zwei alternative Ausführungsformen für die Diodenzweige des Gleichrichters und den Entladewiderstand von Fig. 4; und
die Fig. 8 bis 10 alternative Schaltungsvarianten für den Anschluß der Oszillatoren an den Resonanzkreis.

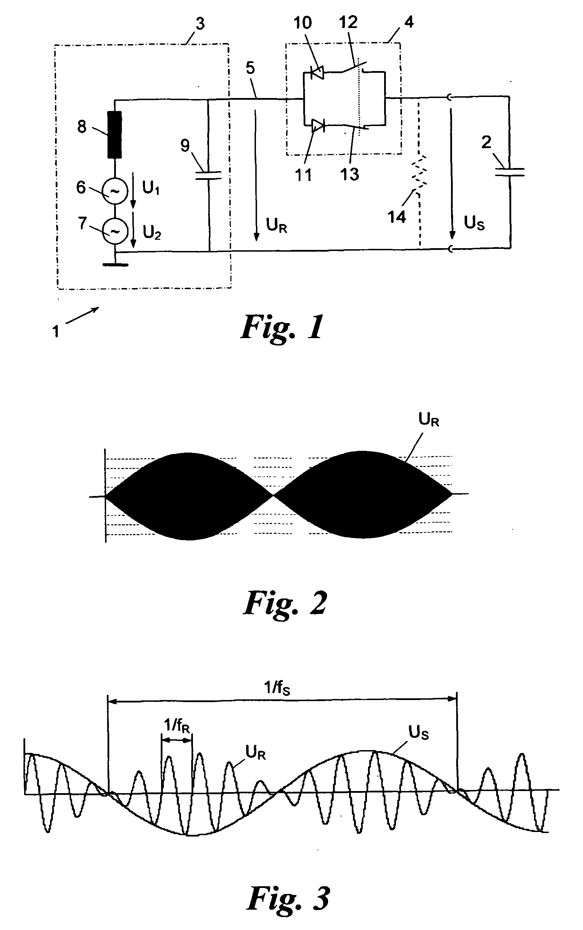

In Fig. 1 ist ein Prüfgenerator 1 dargestellt, der eine Hochspannung $U_S$ im Bereich von einigen 10 bis einigen 100 kV und mit einer sehr tiefen Frequenz ("very low frequency", VLF) im Bereich von einigen Hertz und darunter erzeugt. Der VLF-Prüfgenerator 1 dient zur Isolationsprüfung einer kapazitiven Last 2, beispielsweise eines unterirdischen Hochspannungskabels. Derartige Lasten 2 haben in der Regel eine Kapazität im Bereich von bis zu einigen μF. Die weitere Meßanordnung für die Isolationsprüfung der Last 2 nach Anlegen der tieffrequenten Hochspannung $U_S$, insbesondere für die Messung der Ausgangsspannung, für begleitende Diagnosemessungen wie Verlustfaktormessungen oder Teilentladungsmessungen usw., ist hier ohne Belang und nicht dargestellt.

Der Prüfgenerator 1 setzt sich im wesentlichen aus einem Oszillatorteil 3 und einem daran angeschlossenen Demodulator 4 zusammen. Der Oszillatorteil 3 erzeugt auf einem Ausgang 5 eine Hochspannung $U_R$ höherer Frequenz, welche mit der genannten Tieffrequenz amplitudenmoduliert ist, und der Demodulator 4 demoduliert das Modulationsprodukt $U_R$, um daraus eine tieffrequente Hochspannung $U_S$ als Generatorausgangsspannung zu gewinnen und an die Last 2 anzulegen.

Wie in Fig. 1 gezeigt, umfaßt der Oszillatorteil 3 zwei Oszillatoren 6, 7, deren Oszillatorfrequenzen $f_1$,

$f_2$ sich um das Doppelte der gewünschten Tieffrequenz $f_S$ der Generatorausgangsspannung $U_S$ unterscheiden, d.h. $f_2 - f_1 = 2f_S$. Die Oszillatorfrequenzen $f_1$, $f_2$ sind bevorzugt wesentlich höher als die übliche Netzfrequenz elektrischer Energieverteilungsnetze (50 bzw. 60 Hz), und zwar in der Regel im Bereich von 100 Hz bis 10 kHz, bevorzugt im Bereich von 500 Hz bis 5 kHz, und besonders bevorzugt rund um 1 kHz, z.B. $f_1$ = 1000,0 Hz und $f_2$ = 1000,2 Hz.

Die Oszillatoren 6, 7 speisen gemeinsam in Serienschaltung einen durch eine Drossel 8 und einen Kondensator 9 gebildeten Resonanzkreis. Durch die gegenseitige Überlagerung bzw. Interferenz der Oszillatorausgangsspannungen $U_1$, $U_2$ stellt sich ein Interferenzprodukt im Resonanzkreis 8, 9 ein, das als Schwingung der Frequenz

$$f_R = \frac{f_1 + f_2}{2}$$

aufgefaßt werden kann, im weiteren als Resonanzspannung $U_R$ bezeichnet, welche mit einer tieffrequenten Schwebung $U_S$ der Frequenz

$$f_S = \frac{f_2 - f_1}{2}$$

amplitudenmoduliert ist, wie in der Fig. 2 und 3 gezeigt.

Da in dem genannten Beispiel $f_S$ = 0,1 Hz beträgt, ist die 10.000-fach höherfrequente Resonanzspannung $U_R$ in Fig. 2 nur als Fläche ersichtlich; zur besseren Erkennbarkeit ist in Fig. 3 die Resonanzspannung $U_R$ mit nicht-maßstäblich vergrößerter Periode dargestellt.

Durch die Serienschaltung der Oszillatoren 6,7 beträgt die Amplitude der Erregerspannung $U_1 + U_2$ des Resonanzkreises 8, 9 das Doppelte der Amplituden der einzelnen Oszillatorausgangsspannungen $U_1$, $U_2$. Der Resonanzkreis 8, 9 ist auf die Frequenz $f_R$ der Erregerspannung $U_1 + U_2$ abgestimmt, so daß die Resonanzspannung $U_R$ am Resonanzkreis um die Güte Q des Resonanzkreises gegenüber den erregenden Oszillatorspannungen $U_1 + U_2$ spannungsüberhöht ist und damit das $2 \cdot$ Q-fache einer der Oszillatorausgangsspannungen $U_1$, $U_2$ erreicht.

Bevorzugt liegt die Güte Q des Resonanzkreises 8, 9 zwischen 10 und 100, besonders bevorzugt zwischen 50 und 80. Auf diese Weise kann durch die Spannungsinterferenz und die Spannungsüberhöhung im Resonanzfall des Resonanzkreises 8, 9 aus Oszillatorausgangsspannungen $U_1$, $U_2$ im Bereich von 3-400 V eine Resonanzspannung $U_R$ im Bereich von z.B. 60-80 kV erzeugt werden.

Zum Auskoppeln der tieffrequenten Hochspannung $U_S$ aus dem Resonanzkreis 8, 9 verwendet der hier dargestellte Demodulator 4 die Last 2 mit, u.zw. indem diese über einen geschalteten Gleichrichter 10 - 13 im Takt der Tieffrequenz $f_S$ umgeladen wird. Zu diesem Zweck umfaßt der Demodulator 4 zwei antiparallele Diodenzweige 10, 11, die mittels entsprechender Schalter 12, 13 bei jeder Halbwelle der Tieffrequenz $f_S$ wechselweise an den Ausgang 5 des Resonanzkreises 8, 9 angeschaltet werden.

Um einen allfälligen Spannungssprung im Nulldurchgang der Generatorausgangsspannung $U_S$ zu verhindern, welcher beispielsweise durch Spannungsabfälle im Gleichrichter 10 - 13 und/oder Restladungen in der Last 2 bedingt ist, kann nach dem Stand der Technik ein Entladewiderstand 14 der Last 2 parallelgeschaltet werden. Der Entladewiderstand 14 kann permanent - oder mit Hilfe eines (nicht dargestellten) Schalters nur während der Phase des Nulldurchgangs der Ausgangsspannung $U_S$ - der Last 2 parallelgeschaltet werden.

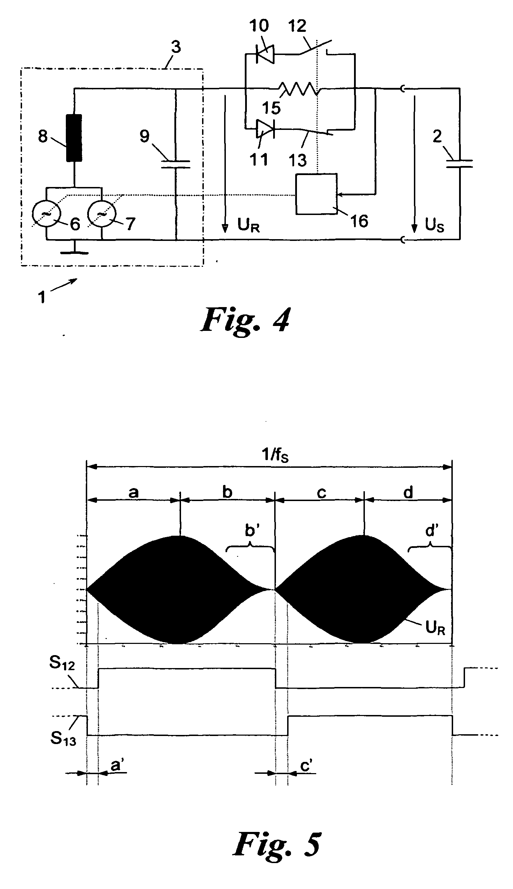

Anstelle eines solchen (schaltbaren) lastparallelen Entladewiderstandes 14 nach dem Stand der Technik, welcher hohe Verlustleistung und/oder zusätzliche Schaltelektronik bedingt, wird die folgende Entladeschaltung gemäß Fig. 4 eingesetzt.

Fig. 4 zeigt eine alternative Ausführungsform des VLF-Generators von Fig. 1, wobei gleiche Bezugszeichen gleiche Teile bezeichnen. Alternativ zu Fig. 1 sind bei dieser Ausführungsform die beiden Oszillatoren 6, 7 einander parallelgeschaltet und interferieren über ihre Ausgangsströme, es kann aber auch die Serienschaltung von Fig. 1 verwendet werden.

Bei der Ausführungsform von Fig. 4 liegt dem Demodulator 4 (bzw. genauer seinen schaltbaren Diodenzweigen 10, 11) ein Entladewiderstand 15 parallel und entlädt die Last 2 zum Potential des Ausgangs 5 des Oszillatorteils 3 hin. Dadurch ist der Entladewiderstand 15 gerade in der Nulldurchgangsphase der Ausgangsspannung $U_S$ besonders wirksam, weil dort auch der Ausgang 5 aufgrund der Knotenpunkte der Resonanzfrequenz $U_R$ gegen Nullpotential geht.

Die Wirksamkeit des Entladewiderstandes 15 kann erhöht werden, indem gemäß Fig. 5 in den jeweils zweiten Vierteln b, d der vier Viertel a - d der Periode der Tieffrequenz $f_S$ die Ausgangsspannungen $U_1$, $U_2$ der Oszillatoren 6, 7 geringfügig reduziert werden, und zwar insbesondere im Endteil b', d' der Viertel b, d, so daß die Hüllkurve der Resonanzspannung $U_R$ dort keinen exakt sinusförmigen Verlauf mehr hat. Der konkrete zeitliche Verlauf dieser Spannungsreduktion wird dabei mit Hilfe einer Steuerung 16, welche die Generatorausgangsspannung $U_S$ mißt, in einem Regelkreis so geregelt, daß sich unter Berücksichtigung der Spannungsabfälle in den Diodenzweigen 10, 11 und Schaltern 12, 13 und der Restladungen in der Last 2 insgesamt ein möglichst sinusförmiger Verlauf der Generatorausgangsspannung $U_S$ ergibt.

Der dem Demodulator 4 parallelgeschaltete Entladewiderstand 15 hat ein gewisses Übersprechen der Hochfrequenz $f_R$ auf die Ausgangsfrequenz $f_S$ zur Folge. Durch entsprechende Dimensionierung des Entladewiderstandes 15 und Steuerung der Spannungsreduzierung in den Bereichen b', d' kann dieser Effekt soweit minimiert werden, daß der Verzerrungsgrad bzw. Klirrfaktor der Generatorausgangsspannung $U_S$ z.B. unter 5% THD liegt.

Das Entladen der Last 2 beim Umschalten des Gleichrichters 10 - 13 kann noch durch eine weitere Maßnahme gefördert werden. In Fig. 5 sind die Schaltschemata $S_{12}$, $S_{13}$ der Schalter 12, 13 im zeitlichen Verlauf gezeigt. Wie ersichtlich, können sich die Ansteuerungen $S_{12}$, $S_{13}$ der Schalter 12, 13 während des Umschaltvorganges geringfügig überlappen, u.zw. so, daß die Schalter 12, 13 unmittelbar nach dem Nulldurchgang der Resonanzspannung $U_R$ kurzfristig beide gleichzeitig geschlossen sind (Bereiche a', c'). Dadurch kann der Einschwingvorgang der Generatorausgangsspannung $U_S$ beim Umschalten des Gleichrichters 10 - 13 minimiert und damit eine noch bessere Annäherung an einen ideal sinusförmigen Verlauf erreicht werden.

In dem gezeigten Beispiel einer VLF-Periodendauer $1/f_S$ von 10 s beträgt die Schließüberlappung a', c' bevorzugt ca. 0,1 s. Allgemein liegt die Schließüberlappung a', c' im Bereich von einigen Tausendstel bis einigen Hunderstel von $1/f_S$.

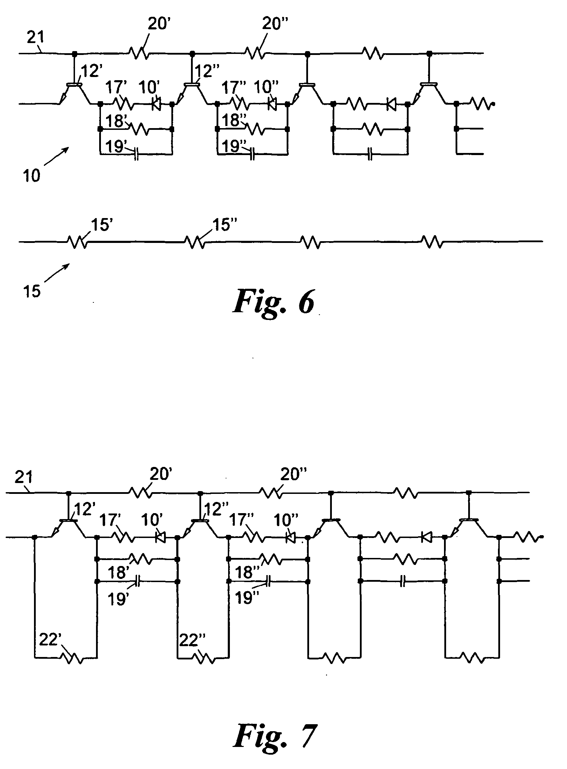

Fig. 6 zeigt eine erste praktische Ausführungsform für den Diodenzweig 10 und den Entladewiderstand 15 (Diodenzweig 11 ist spiegelbildlich). Wie in der Hochspannungstechnik bekannt, wird der Diodenzweig 10 bevorzugt durch eine Kette von einzelnen Dioden 10', 10" usw. und zwischenliegenden einzelnen Halbleiterschaltern 12', 12" usw. gebildet. Jede Diode 10', 10" ist mit einem seriellen Strombegrenzungswiderstand 17', 17" usw., einem parallelen Prüfwiderstand 18', 18" usw. und einem parallelen Schutzkondensator 19', 19" usw. beschaltet.

Die Ansteuerung der Halbleiterschalter 12', 12" ist durch eine mit Widerständen 20', 20" usw. versehene Steuerleitung 21, über welche das Schaltsignal $S_{12}$ zugeführt wird, schematisch versinnbildlicht; die konkrete Ansteuerschaltungen für die Halbleiterschalter 12', 12" ist dem Fachmann bekannt und hier nicht näher dargestellt. Der Entladewiderstand 15 ist zur Erhöhung der Spannungsfestigkeit aus seriengeschalteten Einzelwiderständen 15', 15" usw. zusammengesetzt.

Wie in Fig. 7 gezeigt, können optional die parallelen Prüfwiderstände 18', 18" der Dioden 10', 10" zur Bildung des Entladewiderstandes 15 mitverwendet werden. Zu diesem Zweck werden den Halbleiterschaltern 12', 12" Widerstände 22', 22" usw. parallelgeschaltet, welche gemeinsam mit den Prüfwiderständen 18', 18" - sowie der parallel dazu liegenden Widerstandskette des spiegelbildlichen Diodenzweiges 11 (nicht gezeigt) - den Entladewiderstand 15 bilden.

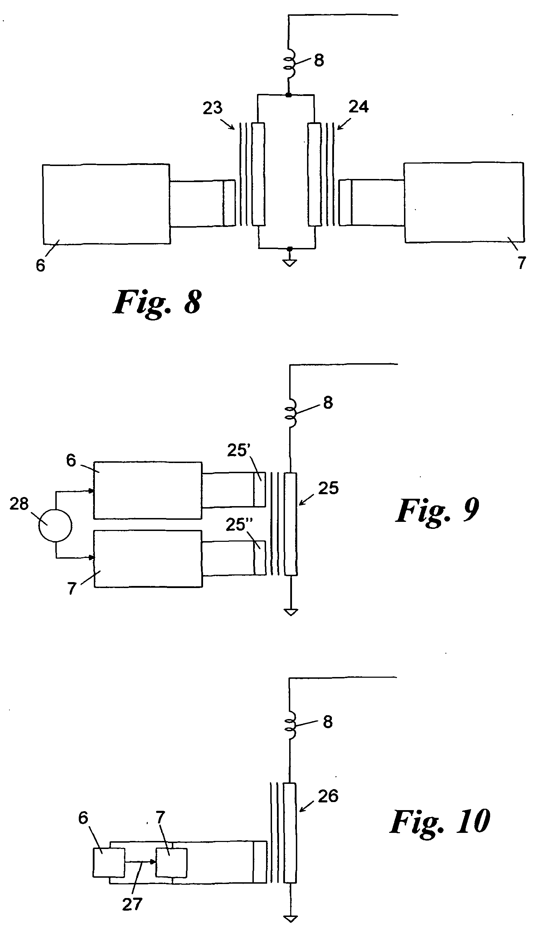

Die Fig. 8 bis 10 zeigen verschiedene praktische Ausführungen der Oszillatoren 6, 7 und deren Anbindung an den Resonanzkreis 8, 9 (nur teilweise dargestellt). Die Oszillatoren 6, 7 werden hier jeweils durch Halbleiter-Wechselrichter gebildet, deren Ausgangsspannungen mikroprozessorgesteuert sowohl in Frequenz als auch Amplitude beliebig regelbar sind (sog. "Power Module").

Bei der Ausführungsform von Fig. 8 speist jeder Oszillator 6, 7 den Resonanzkreis 8, 9 über einen eigenen Hochspannungstransformator 23, 24. Die Transformatoren 23, 24 dienen mehreren Zwecken: zur galvanischen Trennung der Oszillatoren 6, 7 vom Resonanzkreis 8, 9; zur galvanischen Trennung voneinander, zur Darbietung einer induktiven Last für die Oszillatoren 6, 7; und zum zusätzlichen Hochtransformieren der Oszillatorausgangsspannungen $U_1$, $U_2$ für die Anregung des Resonanzkreise 8, 9. Beispielsweise können damit Oszillatorausgangsspannungen $U_1$, $U_2$ von ca. 400 V auf eine Resonanzkreis-Erregerspannung von ca. 4 kV hochtransformiert werden, so daß mit einem Resonanzkreis der Güte Q = 100 eine Generatorausgangsspannung $U_S$ von ca. 400 kV erreicht werden kann.

Bei der Ausführungsform von Fig. 9 teilen sich die beiden Oszillatoren 6, 7 einen gemeinsamen Transformator 25, wobei jeder Oszillator eine eigene Primärwicklung 25', 25" des Transformators 25 speist, die auf dem Transformatorkern in Serie liegen, so daß sich hier wieder eine Spannungsinterferenz der Oszillatorausgangsspannungen $U_1$, $U_2$ ergibt.

Fig. 10 zeigt schließlich eine weitere Ausführungsform, bei welcher ein einziger Hochspannungstransformator 26 Verwendung findet, an dessen Primärwicklung die Oszillatoren 6, 7 in galvanischer Parallelschaltung (oder Serienschaltung, nicht gezeigt) angeschlossen sind; sodaß die Interferenz der Oszillatoren hier durch Strominterferenz (bzw. Spannungsinterferenz, nicht gezeigt) im Primärkreis erfolgt.

Wie durch den Pfeil 27 in Fig. 10 versinnbildlicht, kann die Oszillatorfrequenz $f_2$ des einen Oszillators 7 von der Oszillatorfrequenz $f_1$ des anderen Oszillators 6 abgeleitet sein, wodurch eine hohe Konstanz der Schwebungsfrequenz $f_S = (f_2 - f_1)/2$ erreicht werden kann. Alternativ können die Oszillatorfrequenzen $f_1$, $f_2$ der Oszillatoren 6, 7 auch von einem gemeinsamen Taktgeber 28 abgeleitet sein, siehe Fig. 9.

Wenn keine besonders hohe Ausgangsspannung $U_S$ erforderlich ist, können anstelle der spannungsübersetzenden Hochspannungstransformatoren 23 - 26 auch Anpaßtransformatoren zur Impedanzanpassung und galvanischen Trennung verwendet werden.

Die Erfindung ist nicht auf die dargestellten Ausführungsbeispiele beschränkt, sondern umfaßt alle Varianten und Modifikationen, insbesondere auch beliebige Kombinationen der gezeigten Ausführungsbeispiele, die in den Rahmen der angeschlossenen Ansprüche fallen.

**Patentansprüche**

1. VLF-Prüfgenerator (1) zur Erzeugung einer Hochspannung ($U_S$) mit Tieffrequenz ($f_S$) für die Isolationsprüfung von kapazitiven Lasten (2), insbesondere Energiekabeln, mit einem Oszillatorteil (3), der auf einem Ausgang (5) eine Hochspannung $U_R$) hoher Frequenz ($f_R$) erzeugt, die mit der Tieffrequenz ($f_S$) moduliert ist, und einem daran angeschlossenen Demodulator (4) zum Demodulieren der Hochspannung ($U_R$) und Wiedergewinnen der Tieffrequenz ($f_S$) daraus, **dadurch gekennzeichnet, daß** dem Demodulator (4) ein zum genannten Ausgang (5) zurückführender Entladewiderstand (15) für die kapazitive Last (2) parallelgeschaltet ist.

2. VLF-Prüfgenerator nach Anspruch 1, bei welchem der Demodulator die kapazitive Last mitverwendet und diese mittels eines Gleichrichters im Takt der Tieffrequenz umlädt, **dadurch gekennzeichnet, daß** der Entladewiderstand (15) dem Gleichrichter (10 - 13) parallelgeschaltet ist.

3. VLF-Prüfgenerator nach Anspruch 2, bei welchem der Gleichrichter zwei antiparallele, mit Schaltern versehene Diodenzweige aufweist, wobei die Schalter zwischen den Diodenzweigen abwechselnd umschalten, **dadurch gekennzeichnet, daß** der Entladewiderstand (15) den beiden Diodenzweigen (10, 11) parallelgeschaltet ist.

4. VLF-Prüfgenerator nach Anspruch 3, **dadurch gekennzeichnet, daß** jeder Diodenzweig (10, 11) durch eine Kette von Dioden (10', 10") und zwischenliegenden Halbleiterschaltern (12', 12") gebildet ist, wobei jeder Diode und jedem Halbleiterschalter ein Widerstand (18', 18", 22', 22") parallelgeschaltet ist, welche gemeinsam den genannten Entladewiderstand (15) bilden.

5. VLF-Prüfgenerator nach Anspruch 3 oder 4, **dadurch gekennzeichnet, daß** die Schalter (12, 13) beim Umschalten kurzfristig überlappend (a', c') gleichzeitig geschlossen sind.

6. VLF-Prüfgenerator nach einem der Ansprüche 1 bis 5, **dadurch gekennzeichnet, daß** eine Steuereinrichtung (16) für den Oszillatorteil (3) vorgesehen ist, welche die Amplitude der Hochspannung ($U_R$) am Ende (b', d') jedes zweiten Viertels (b, d) der Periode der Tieffrequenz ($f_S$) reduziert, um die Entladung der kapazitiven Last (2) über den Entladewiderstand (15) zu unterstützen.

7. VLF-Prüfgenerator nach einem der Ansprüche 1 bis 6, **dadurch gekennzeichnet, daß** der Oszillatorteil (3) zwei Oszillatoren (6, 7), deren Oszillatorfrequenzen ($f_1$, $f_2$) sich um das Doppelte der genannten Tieffrequenz ($f_S$) voneinander unterscheiden, und einen von den Oszillatoren (6, 7) interferierend gespeisten, auf die Oszillatorfrequenzen ($f_1$, $f_2$) abgestimmten Resonanzkreis (8, 9) zur Spannungsüberhöhung ($U_R$) der interferierenden Oszillatorfrequenzen aufweist, wobei der Demodulator (4) die durch die Interferenz erzeugte Tieffrequenz ($U_S$) aus dem Resonanzkreis (8, 9) auskoppelt und an die Last (2) anlegt.

8. VLF-Prüfgenerator nach Anspruch 7, **dadurch gekennzeichnet, daß** die Oszillatoren (6, 7) den Resonanzkreis (8, 9) über zumindest einen Transformator (23 - 26) speisen.

9. VLF-Prüfgenerator nach Anspruch 8, **dadurch gekennzeichnet, daß** der Transformator (23 - 26) die Oszillatorausgangsspannungen ($U_1$, $U_2$) hochtransformiert.

10. VLF-Prüfgenerator nach einem der Ansprüche 7 bis 9, **dadurch gekennzeichnet, daß** jeder Oszillator (6, 7) durch einen steuerbaren Halbleiter-Wechselrichter gebildet ist.

## Claims

1. VLF test generator (1) for generating a high voltage ($U_S$) with a low frequency ($f_S$) for testing the insulation of capacitive loads (2), in particular power cables, having an oscillator part (3) which generates at an output (5) a high voltage ($U_R$) which has a high frequency ($f_R$) and is modulated with a low frequency ($f_S$), and a demodulator (4) connected thereto for demodulating the high voltage ($U_R$) and recovering the low frequency ($f_S$) therefrom, **characterised in that** a discharging resistor (15) for the capacitive load (2) which leads back to said output (5) is connected in parallel to the demodulator (4).

2. VLF test generator according to claim 1, in which the demodulator co-uses the capacitive load and reverses the latter by means of a rectifier in step with the low frequency, **characterised in that** the discharging resistor (15) is connected in parallel to the rectifier (10-13).

3. VLF test generator according to claim 2, in which the rectifier comprises two antiparallel diode branches provided with switches, the switches alternately changing over between the diode branches, **characterised in that** the discharging resistor (15) is connected in parallel to the two diode branches (10, 11).

4. VLF test generator according to claim 3, **characterised in that** each diode branch (10, 11) is formed by a chain of diodes (10', 10") and interposed semiconductor switches (12', 12"), a resistor (18', 18", 22', 22") being connected in parallel to each diode and each semiconductor switch, said resistors jointly forming the said discharging resistor (15).

**5.** VLF test generator according to claim 3 or claim 4, **characterised in that**, on changeover, the switches (12, 13) are briefly closed simultaneously and overlappingly (a', c').

**6.** VLF test generator according to any one of claims 1 to 5, **characterised in that** a control device (16) is provided for the oscillator part (3), which control device reduces the amplitude of the high voltage ($U_R$) at the end (b', d') of each second quarter (b, d) of the period of the low frequency ($f_S$) in order to assist discharge of the capacitive load (2) via the discharging resistor (15).

**7.** VLF test generator according to any one of claims 1 to 6, **characterised in that** the oscillator part (3) comprises two oscillators (6, 7), the oscillator frequencies ($f_1$, $f_2$) of which differ from one another by twice the stated low frequency ($f_S$), and a resonant circuit (8, 9) supplied interferingly by the oscillators (6, 7), which is tuned to the oscillator frequencies ($f_1$, $f_2$) for voltage superelevation ($U_R$) of the interfering oscillator frequencies, the demodulator (4) outcoupling the low frequency ($U_S$) generated by the interference from the resonant circuit (8, 9) and applying it to the load (2).

**8.** VLF test generator according to claim 7, **characterised in that** the oscillators (6, 7) supply the resonant circuit (8, 9) via at least one transformer (23-26).

**9.** VLF test generator according to claim 8, **characterised in that** the transformer (23-26) steps up the oscillator output voltages ($U_1$, $U_2$) .

**10.** VLF test generator according to any one of claims 7 to 9, **characterised in that** each oscillator (6, 7) is formed by a controllable semiconductor inverter.

**Revendications**

**1.** Générateur TBF pour essais (1) destiné à produire une haute tension ($U_s$) à une très basse fréquence ($f_s$) pour tester l'isolement de charges capacitives (2), en particulier de câbles d'énergie, comprenant une partie oscillateur (3) qui génère sur une sortie (5) une haute tension ($U_R$) à haute fréquence ($f_R$) modulée par la très basse fréquence ($f_s$), et, relié à cette partie, un démodulateur (4) pour démoduler la haute tension ($U_R$) et récupérer la très basse fréquence ($f_s$) à partir de celle-ci, **caractérisé en ce qu'**une résistance de décharge (15) de la charge capacitive (2) rétrocouplée à ladite sortie (5) est câblée en parallèle avec le démodulateur (4).

**2.** Générateur TBF pour essais selon la revendication 1, dans lequel le démodulateur utilise conjointement la charge capacitive et l'inverse au moyen d'un redresseur au rythme de la très basse fréquence, **caractérisé en ce que** la résistance de décharge (15) est câblée en parallèle avec le redresseur (10 - 13).

**3.** Générateur TBF pour essais selon la revendication 2, dans lequel le redresseur présente deux circuits de diodes antiparallèles munis de commutateurs, lesdits commutateurs basculant alternativement entre les circuits de diodes, **caractérisé en ce que** la résistance de décharge (15) est câblée en parallèle avec les deux circuits de diodes (10, 11).

**4.** Générateur TBF pour essais selon la revendication 3, **caractérisé en ce que** chaque circuit de diodes (10, 11) est formé par une chaîne de diodes (10', 10") et de commutateurs à semi-conducteurs intercalés (12', 12"), des résistances (18', 18", 22', 22") dont l'ensemble forme ladite résistance de décharge (15) étant respectivement câblées en parallèle avec chaque diode et chaque commutateur à semi-conducteur.

**5.** Générateur TBF pour essais selon la revendication 3 ou la revendication 4, **caractérisé en ce que** les commutateurs (12, 13) sont fermés en même temps en se chevauchant brièvement (a', c') lors de l'inversion de polarité.

**6.** Générateur TBF pour essais selon l'une des revendications 1 à 5, **caractérisé en ce qu'**il est prévu pour la partie oscillateur (3) un dispositif de commande (16) qui réduit l'amplitude de la haute tension ($U_R$) à la fin (b', d') de chaque deuxième quart (b, d) de la période de la très basse fréquence ($f_s$) afin d'assister la décharge de la charge capacitive (2) par le biais de la résistance de décharge (15).

**7.** Générateur TBF pour essais selon l'une des revendications 1 à 6, **caractérisé en ce que** la partie oscillateur (3) présente deux oscillateurs (6, 7) dont les fréquences d'oscillation ($f_1$, $f_2$) diffèrent d'une valeur égale au double de ladite très basse fréquence ($f_s$), et un circuit résonant (8, 9) adapté aux fréquences d'oscillation ($f_1$), $f_2$) et alimenté en mode interférentiel par les oscillateurs (6, 7) pour produire une élévation de tension ($U_R$) des fréquences d'oscillation interférentielle, le démodulateur (4) découplant la très basse fréquence ($U_S$) générée par l'interférence du circuit résonant (8, 9) pour l'appliquer à la charge (2).

**8.** Générateur TBF pour essais selon la revendication 7, **caractérisé en ce que** les oscillateurs (6, 7) alimentent le circuit résonant (8, 9) par le biais d'au moins un transformateur (23 - 26).

**9.** Générateur TBF pour essais selon la revendication 8, **caractérisé en ce que** le transformateur (23 - 26) élève les tensions de sortie des oscillateurs ($U_1$, $U_2$).

**10.** Générateur TBF pour essais selon l'une des revendications 7 à 9, **caractérisé en ce que** chaque oscillateur (6, 7) est formé par un circuit onduleur à semi-conducteurs commandables.

**Fig. 1**

**Fig. 2**

**Fig. 3**

**Fig. 4**

**Fig. 5**

**Fig. 6**

**Fig. 7**

**Fig. 8**

**Fig. 9**

**Fig. 10**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10333241 B